# EUROPÄISCHE PATENTSCHRIFT

(11) **EP 1 305 803 B1**
(45) Veröffentlichungstag und Bekanntmachung des Hinweises auf die Patenterteilung: **14.11.2007**
(21) Anmeldenummer: 01964846.8
(22) Anmeldetag: 24.07.2001
(51) Int. Cl.: G11C 7/04

(54) **INTEGRIERTE SCHALTUNG MIT TEMPERATURSENSOR**
INTEGRATED CIRCUIT WITH A TEMPERATURE SENSOR
CIRCUIT INTEGRE COMPORTANT UN CAPTEUR DE TEMPERATURE

(30) Priorität: 28.07.2000 DE 10036914
(43) Veröffentlichungstag der Anmeldung: 02.05.2003
(73) Patentinhaber: Infineon Technologies AG, 81669 München (DE)
(72) Erfinder: BARTH, Roland, Sunnyvale,CA 94087 (US); BENEDIX, Alexander, 81739 München (DE); DUEREGGER, Reinhard, 85586 Poing (DE); GROSSE, Stephan, 81379 München (DE)
(74) Vertreter: Epping - Hermann - Fischer
(86) Internationale Anmeldenummer: PCT/DE2001/002802
(87) Internationale Veröffentlichungsnummer: WO 2002/011147

(56) Entgegenhaltungen:
- DE-A- 19 638 973
- US-A- 5 875 142
- US-A- 6 002 240
- US-A- 6 009 033

## Beschreibung

Die vorliegende Erfindung betrifft eine integrierte Schaltung auf einem Halbleiterchip, in der ein Temperatursensor integriert ist.

Integrierte Schaltungen arbeiten in einem sehr breiten Temperaturbereich. Wenn verlangt wird, dass die Schaltung auch bei sehr niedrigen Temperaturen einwandfrei arbeitet, müssen zumindest stichprobenartig einzelne Exemplare der Schaltung auch bei tiefen Temperaturen getestet werden. Mit dieser zusätzlichen Selektion verringert sich aber die Ausbeute brauchbarer Schaltungen erheblich. Dieses Problem tritt insbesondere bei Speicherbausteinen wie z. B. DRAMs auf.

In der US 5,875,142 ist ein IC-Chip mit einem integrierten Temperatursensor beschrieben, der dazu dient, die Funktion der integrierten Schaltung in Abhängigkeit von der gemessenen Temperatur zu regeln und in unterschiedliche Betriebsmodi zu versetzen. Eine Kontrollschaltung passt die Betriebsparameter des ICs an die gemessene Temperatur an.

Aufgabe der vorliegenden Erfindung ist es, eine integrierte Schaltung mit hoher Betriebssicherheit auch bei tiefen Temperaturen anzugeben.

Diese Aufgabe wird mit der integrierten Schaltung mit den Merkmalen des Anspruches 1 gelöst. Ausgestaltungen ergeben sich aus den abhängigen Ansprüchen.

Bei der erfindungsgemäßen integrierten Schaltung auf einem Halbleiterchip ist zusammen mit der Schaltung auf diesem Chip mindestens ein Temperatursensor integriert, der ein von der Temperatur abhängiges Messsignal liefert oder zumindest dann ein Signal abgibt, wenn die Chiptemperatur unter einen bestimmten vorgegebenen Wert absinkt. Für diesen Fall ist auf dem Chip eine spezielle Schaltungseinrichtung vorhanden, mit der ein Stromfluss durch eine vorhandene Struktur elektrischer Leiter hervorgerufen wird, mit dem in ausreichender Menge Wärme erzeugt wird, um die Temperatur der integrierten Schaltung über einer vorgegebenen Mindesttemperatur zu halten. Eine solche integrierte Schaltung erhöht nicht nur die Ausbeute der bei tiefen Temperaturen einwandfrei funktionierenden Chips, sondern lässt sich überdies bei tieferen Temperaturen als bisher möglich einsetzen.

Die Struktur elektrischer Leiter braucht nur so beschaffen zu sein, dass der hindurchfließende Strom in dem ohmschen Widerstand des Leiters eine ausreichende Wärmemenge erzeugt, um die gewünschte Heizwirkung zu erreichen. Diese Leiter können also insbesondere die auf einer integrierten Schaltung ohnehin vorgesehenen Leiterbahnen sein, die nach Bedarf mit der speziellen Schaltungseinrichtung zur Generierung des Stromflusses elektrisch leitend verbunden werden.

Im Fall eines Halbleiterspeichers können diejenigen Leiter einzelner Speicherblöcke (Bänke) verwendet werden, die bei einem aktuellen Speichervorgang oder Auslesevorgang nicht benötigt werden. Die Leiter sind dann insbesondere die Adressleitungen, über die die gespeicherten Signale den Speicherzellen zugeführt oder aus diesen ausgelesen werden. Über die Ansteuerschaltung des Speichers wird bestimmt, welche Bänke des Speicherchips zur Erzeugung eines Heizstromes jeweils aktuell zur Verfügung stehen. Die spezielle Schaltungseinrichtung wird nach Bedarf mit den gegenwärtig nicht benutzten Leitern der deaktivierten Speicherblöcke zusammengeschaltet.

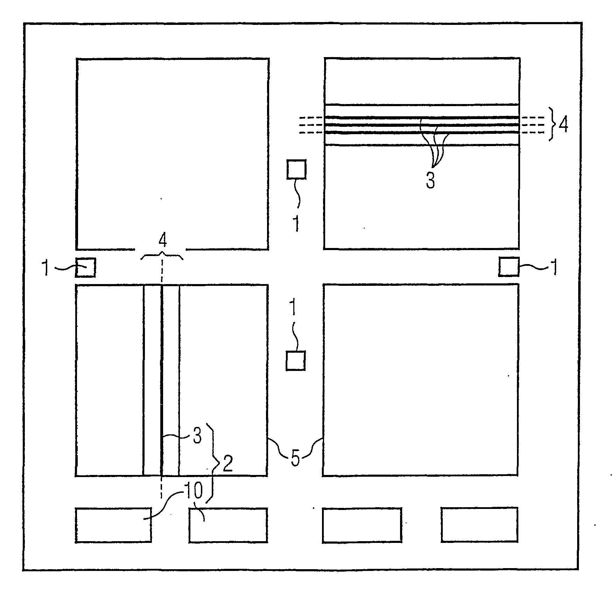

Zur genaueren Erläuterung ist in der Figur ein Beispiel der erfindungsgemäßen integrierten Schaltung im Schema in Aufsicht dargestellt.

Auf der Oberseite des Halbleiterchips sind in dem Beispiel der Figur mehrere Temperatursensoren 1 angeordnet. Die elektrischen Leiter 2 sind durch die Adressleitungen 3 eines jeweils nicht aktivierten Teilbereiches 4 eines Speichers oder durch Dummyzellen 10 am Rand des Speicherzellenfeldes gebildet. Die verschiedenen Bänke 5 des Speichers sind nicht alle gleichzeitig aktiviert. Daher können die in den nicht aktivierten Bänken vorhandenen Leiter für ein Aufheizen des Chips verwendet werden. Die Auswahl der Leiter und die Erzeugung des Stromflusses erfolgt in der speziellen Schaltungseinrichtung. Die elektronischen Bauelemente der speziellen Schaltungseinrichtung können ebenso wie die der Ansteuerschaltung des Speichers zwischen den Speicherbänken oder am Rand des Halbleiterchips angeordnet sein und sind in der Figur nicht gesondert eingezeichnet.

Als Temperatursensor 1 kommt hier grundsätzlich jeder mikroelektronische integrierbare Temperatursensor in Frage. Derartige Bauelemente sind an sich bekannt und werden bislang zusammen mit den zugehörigen Bauelementen einer elektronischen Ansteuer- und Auswerteschaltung auf demselben Chip integriert. Von der Herstellungstechnologie her stellt die erfindungsgemäße integrierte Schaltung daher prinzipiell keine weitergehenden Anforderungen.

An den für die Wärmeerzeugung verwendeten elektrischen Leiter ist nur die Anforderung zu stellen, dass er einen geeignet hohen ohmschen Widerstand aufweist und so strukturiert ist, dass die erzeugte Wärme in die aufzuwärmenden Bereiche des Chips gelangt. Es ist nicht notwendig, dass der Leiter die Pole der angelegten Potentialdifferenz elektrisch leitend miteinander verbindet. Gerade bei einem Halbleiterspeicher ist es von Vorteil, wenn eine auf dem Chip ohnehin vorhandene ausreichend große Kapazität, die z. B. durch Kontaktflächen gebildet werden kann, verwendet wird, indem sie mit einer Wechselspannung ausreichend hoher Frequenz beaufschlagt wird. Da die Kapazität mit steigender Wechselspannungsfrequenz zunehmend als Kurzschluss wirkt, wird auch auf diese Weise ein für eine Erwärmung der ohmschen Widerstände der Zuführungsleitungen ausreichend großer Stromfluss erzeugt.

Bei Halbleiterchips, die als Speicherchips für einen DRAM vorgesehen sind, ist die Realisierung einer Heizfunktion z. B. durch schnell aufeinander folgende Refresh-Zyklen möglich. Eine mögliche Implementierung dieser Heizfunktion benutzt die gerade nicht aktiven Bereiche der Speicherbänke (z. B. beim Standard-SDRAM vier Segmente der On-Chip-Bänke dafür verfügbar), die zur Aufheizung verwendet werden und durch Activate- und Precharge-Befehle betrieben werden.

Um die Möglichkeit eines Datenverlusts durch die hohe Beanspruchung der Speicherzellen zu verhindern, kann man für die Wärmeerzeugung auch zusätzlich oder vorzugsweise ausschließlich die so genannten Dummyzellen am Rande des Speicherzellenfeldes verwenden. Diese Dummyzellen werden in der Regel vorgesehen, um die optischen Eigenschaften des Chips am Zellenfeldrand für die lithographischen Prozessschritte zu verbessern. Da sie im allgemeinen keine eigene elektrische Funktion besitzen, sind sie bevorzugt für eine Verwendung als Heizleiter geeignet.

Die Aufheizfunktion, die über die spezielle Schaltungseinrichtung gesteuert wird, kann nach Bedarf auch durch externe Kommandos (Activate, Precharge, Read etc.) unterbrochen werden, so dass die Funktionalität einer erfindungsgemäßen Speicherzellenanordnung nicht beeinträchtigt wird. Insbesondere kann die Heizfunktion durch ein Signal angezeigt werden, das im Fall eines vorhandenen Stromflusses durch die dafür vorgesehenen Heizleiter von der speziellen Schaltungseinrichtung erzeugt wird. Dieses Signal kann einer externen Schaltung zugeführt werden, die das Aufheizen bei Bedarf unterbricht. Vorzugsweise erfolgt diese Unterbrechung des Stromflusses in bestimmten vorgesehenen Betriebszuständen der integrierten Schaltung automatisch bereits durch die spezielle Schaltungseinrichtung selbst. Diese Schaltung ist dann dafür vorgesehen, die gesamte Aufheizfunktion so zu steuern, dass die Funktion der eigentlichen integrierten Schaltung des Halbleiterchips in keiner Weise beeinträchtig wird, sondern nur für eine die korrekte Betriebsweise garantierende Mindesttemperatur des Chips gesorgt wird.

## Patentansprüche

1. Integrierte Schaltung auf einem Halbleiterchip, bei der ein Temperatursensor (1) integriert ist,
eine Struktur elektrischer Leiter (2) vorhanden ist und
eine spezielle Schaltungseinrichtung auf dem Chip vorhanden ist, die dafür vorgesehen ist, in Abhängigkeit von einem Messsignal des Temperatursensors einen Stromfluss durch die Struktur elektrischer Leiter hervorzurufen, um den Betrieb der Schaltung zu verändern,
**dadurch gekennzeichnet, dass**
die Struktur elektrischer Leiter (2) so beschaffen ist, dass ein hindurchfließender Strom in dem ohmschen Widerstand des Leiters eine ausreichende Wärmemenge erzeugt, um eine vorgesehene Heizwirkung zu erreichen,
die spezielle Schaltungseinrichtung so beschaffen ist, dass damit in Abhängigkeit von einem Messsignal des Temperatursensors ein Stromfluss durch die besagten Leiter hervorgerufen wird, wenn die festgestellte Temperatur unter einen vorgegebenen Wert absinkt, um die Temperatur der integrierten Schaltung über einer vorgegebenen Mindesttemperatur zu halten.

2. Integrierte Schaltung nach Anspruch 1, bei der
die Schaltung ein Halbleiterspeicher ist,
die besagten Leiter (2) jeweils durch Adressleitungen (3) in einem jeweiligen Teilbereich (4) des Speichers gebildet sind und
die Schaltung so vorgesehen ist, dass die Adressleitungen (3) je nach dem Betriebszustand des Speichers mit der speziellen Schaltungseinrichtung verbunden werden.

3. Integrierte Schaltung nach Anspruch 1 oder 2, bei der
die besagten Leiter (2) durch Dummyzellen (10) am Rand eines Speicherzellenfeldes gebildet werden.

4. Integrierte Schaltung nach Anspruch 2 oder 3, bei der
die spezielle Schaltungseinrichtung dafür vorgesehen ist, durch Befehle zum Ändern des Betriebszustands des Speichers betrieben zu werden.

5. Integrierte Schaltung nach Anspruch 4, bei der
die spezielle Schaltungseinrichtung dafür vorgesehen ist, durch Activate- und Precharge-Kommandos betrieben zu werden.

6. Integrierte Schaltung nach einem der Ansprüche 1 bis 5, bei der
die spezielle Schaltungseinrichtung dafür vorgesehen ist, im Fall eines vorhandenen Stromflusses durch die besagten Leiter Signale zu erzeugen, die in vorgesehenen Betriebszuständen der integrierten Schaltung ein Abschalten des Stromflusses bewirken.

## Claims

1. Integrated circuit on a semiconductor chip, in which integrated circuit
a temperature sensor (1) is integrated,
a structure of electrical conductors (2) is provided, and
a special circuit device is provided on the chip and is intended to cause a flow of current through the structure of electrical conductors on the basis of a measurement signal from the temperature sensor in order to change operation of the circuit,
**characterized in that**
the structure of electrical conductors (2) is such that a current flowing through it generates a sufficient amount of heat in the nonreactive resistance of the conductor to achieve an intended heating effect,
the special circuit device is such that it is used to cause a flow of current through said conductors on the basis of a measurement signal from the temperature sensor if the temperature determined falls below a predefined value in order to keep the temperature of the integrated circuit above a predefined minimum temperature.

2. Integrated circuit according to Claim 1, in which
the circuit is a semiconductor memory,
said conductors (2) are each formed by address lines (3) in a respective subarea (4) of the memory, and
the circuit is provided in such a manner that the address lines (3) are connected to the special circuit device depending on the operating state of the memory.

3. Integrated circuit according to Claim 1 or 2, in which
said conductors (2) are formed by dummy cells (10) at the edge of a memory cell array.

4. Integrated circuit according to Claim 2 or 3, in which
the special circuit device is intended to be operated by commands for changing the operating state of the memory.

5. Integrated circuit according to Claim 4, in which
the special circuit device is intended to be operated by activate and precharge commands.

6. Integrated circuit according to one of Claims 1 to 5, in which,
in the event of a flow of current through said conductors, the special circuit device is intended to generate signals which cause the flow of current to be switched off in intended operating states of the integrated circuit.

## Revendications

1. Circuit intégré sur une puce à semiconducteurs, dans lequel est intégré un capteur (1) de température,
dans lequel est prévue une structure de conducteurs (2) électriques et dans lequel il est présent sur la puce pour un dispositif de circuit spécial, qui est prévu pour, en fonction d'un signal de mesure du capteur de température, provoquer un flux de courant dans la structure de conducteurs électriques, afin de modifier le fonctionnement du circuit,
**caractérisé en ce que** la structure de conducteurs (2) électriques est réalisée de telle manière qu'un courant entrant dans la résistance ohmique du conducteur produit une quantité de chaleur suffisante pour atteindre une capacité calorifique prévue à l'avance,
le dispositif de circuit spécial étant réalisé de telle sorte que, en fonction d'un signal de mesure du capteur de température, il est créé un flux de courant dans les conducteurs mentionnés précédemment si la température déterminée passe en dessous d'une valeur définie à l'avance, afin de maintenir la température du circuit intégré au-dessus d'une température minimale déterminée à l'avance.

2. Circuit intégré suivant la revendication 1, dans lequel le circuit est une mémoire à semiconducteurs, les conducteurs (2) mentionnés étant formés respectivement par des lignes (3) d'adresse dans une région (4) partielle respective de la mémoire et le circuit est réalisé de telle manière que les lignes (3) d'adresse sont reliées suivant l'état de fonctionnement de la mémoire chacune avec le dispositif de circuit spécial.

3. Circuit intégré suivant la revendication 1 ou 2, dans lequel les conducteurs (2) mentionnés sont formés par des cellules (10) dummy au bord d'un champ de cellules de mémoire.

4. Circuit intégré suivant la revendication 2 ou 3, dans lequel le dispositif de circuit spécial est prévu afin d'être mis en fonctionnement par des instructions de modification de l'état de fonctionnement de la mémoire.

5. Circuit intégré suivant la revendication 4, dans lequel le dispositif de circuit spécial est prévu afin qu'il soit mis en fonctionnement par des commandes d'activation et de précharge.

6. Circuit intégré suivant l'une des revendications 1 à 5, dans lequel le dispositif de circuit spécial est prévu afin que dans le cas d'un débit de courant présent passant par les conducteurs mentionnés, des signaux soient produits, qui agissent dans les états de fonctionnement prévus du circuit intégré pour interrompre le flux de courant.
